# EUROPEAN PATENT APPLICATION

(11) **EP 4 756 468 A1**
(43) Date of publication of application: **10.06.2026**
(21) Application number: 23947412.5
(22) Date of filing: 14.12.2023
(51) Int. Cl.: G01R 33/09, G01R 33/06

(54) **Z-AXIS MAGNETIC FIELD SENSOR AND PROCESSING METHOD THEREFOR**

(30) Priority: 01.08.2023 CN 202310960198
(71) Applicant: MultiDimension Technology Co., Ltd., Jiangsu 215634 (CN)
(72) Inventor: LIU, Mingfeng, Jiangsu 215634 (CN); SHI, Ran, Jiangsu 215634 (CN); XUE, Songsheng, Jiangsu 215634 (CN)
(74) Representative: HGF
(86) International application number: PCT/CN2023/138621
(87) International publication number: WO 2025/025475

(57) **Abstract**

The present application provides a Z-axis magnetic field sensor and a processing method therefor, which relates to the technical field of magnetic field measurement. The sensor comprises a substrate, a magnetic flux conversion module, a magnetic induction module, and an output module; a soft magnetic metal material having a high magnetic permeability that forms the magnetic flux conversion module is located in a groove formed by etching in the substrate or located above the substrate, and the magnetic flux conversion module comprises a first magnetic flux conversion unit and a second magnetic flux conversion unit; the first magnetic flux conversion unit and the second magnetic flux conversion unit comprise soft magnetic metal materials spaced apart from each other, which concentrate and amplify a magnetic field to be measured in the Z-axis direction, and then convert the magnetic field direction, thus generating an X-axis magnetic field component. The magnetic induction module senses the magnetic field of the magnetic flux conversion module and generates a differential voltage signal, and by means of the output module, an output signal of the magnetic field to be measured is formed. The Z-axis magnetic field sensor and processing method provided in the present application have the characteristics of high magnetic field conversion efficiency, a uniform magnetic field distribution, high sensitivity, good stability, low noise, and availability single-chip and small-size manufacturing.

## Description

### Technical Field

The present invention relates to the technical field of magnetic field measurement, and specifically, relates to a Z-axis magnetic field sensor and a processing method therefor.

### Background of the Invention

Magnetic sensors are widely used in modem industry and electronic products, and they can measure physical parameters such as current, position, motion, and direction by sensing changes in magnetic field strength. This process usually involves the measurement of the Z-axis magnetic field, that is, the measurement of the magnetic field in the direction normal to the plane where the magnetic sensor is located.

Currently, the measurement of the Z-axis magnetic field is mainly achieved through methods such as detector coils, Hall elements, or magnetoresistive elements. Detector coils have low spatial resolution, limited sensitivity, and limited frequency characteristics; Hall elements have low sensitivity, high power consumption, and poor temperature characteristics; the sensitivity direction of magnetoresistive elements is generally in the in-plane direction, which limits their applications in scenarios such as vertical magnetic field and triaxial vector magnetic field detection.

### Summary of the Invention

To achieve better vertical magnetic field detection, the present invention provides a Z-axis magnetic field sensor and a processing method therefor, so as to solve the problems of low sensitivity, poor accuracy, and high noise in existing Z-axis magnetic field sensors.

A first aspect of the present application provides a Z-axis magnetic field sensor, comprising a substrate, a magnetic flux conversion module, a magnetic induction module, and an output module. The magnetic flux conversion module is disposed in a groove of the substrate or located above the substrate; the magnetic flux conversion module is used to modulate a magnetic field to be measured and generate a magnetic field component in the X-axis direction to form a target magnetic flux path; wherein the direction of the magnetic field to be measured is the Z-axis direction. The magnetic induction module comprises at least two magnetic induction units, the magnetic induction units are arranged between the magnetic flux conversion modules along the Z-axis direction, and the magnetic induction units are used to generate differential voltage signals under the action of the target magnetic flux path; wherein the magnetic induction units comprise at least one magnetoresistive sensitive element, and the sensitivity directions of the magnetic induction units are the same; the magnetic induction module employs at least one structure selected from differential full bridge, differential half bridge, push-pull full bridge, and push-pull half bridge to sense the magnetic field of the magnetic flux conversion module, generate a differential voltage signal, and form an output signal of the magnetic field to be measured through the output module. Here, the plane on which the substrate is located is a plane formed by the X-axis and the Y-axis, the magnetic flux conversion module is disposed along the X-axis direction, and the plane perpendicular to the plane on which the substrate is located is the plane on which the Z-axis is located.

Optionally, the magnetic flux conversion module comprises at least one first magnetic flux conversion unit and at least one second magnetic flux conversion unit; the first magnetic flux conversion unit and the second magnetic flux conversion unit are disposed on two sides of the magnetic induction unit along the Z-axis direction; the first magnetic flux conversion unit and the second magnetic flux conversion unit are used to concentrate and amplify the magnetic field to be measured to form the target magnetic flux path, and generate a magnetic field component in the X-axis direction at the position of spacing between the first magnetic flux conversion unit and the second magnetic flux conversion unit; wherein the projections of the first magnetic flux conversion unit and the second magnetic flux conversion unit on the X-axis do not overlap or the overlapping portion is less than an overlap threshold; and the overlap threshold is related to the measurement range of the magnetic field sensor.

Optionally, the substrate comprises a first substrate and a second substrate. The soft magnetic metal materials of the first magnetic flux conversion unit and the second magnetic flux conversion unit are located inside the grooves of the first substrate and the second substrate, respectively; and the magnetic induction unit is located between the first substrate and the second substrate.

Furthermore, when the magnetic induction units are located in planes formed by different X-axes and Y-axes in the Z-axis direction, the first plane contains at least one magnetic induction unit, and the second plane contains at least one magnetic induction unit; the first plane magnetic induction unit is integrated on the first substrate, and the second plane magnetic induction unit is integrated on the second substrate; the sensitivity directions of the first plane magnetic induction unit and the second plane magnetic induction unit are the same or different.

Optionally, the magnetic flux conversion module further comprises a magnetic flux connection unit made of a soft magnetic metal material with high magnetic permeability. The magnetic flux connection unit is disposed between a plane formed by the X-axis and the Y-axis of the first magnetic flux conversion unit and a plane formed by the X-axis and the Y-axis of the second magnetic flux conversion unit; the soft magnetic metal material of the magnetic flux connection unit is distributed along the X-axis direction, connects the magnetic flux paths of the first magnetic flux conversion unit and the second magnetic flux conversion unit, and guides them along a direction parallel to the X-axis. The magnetic induction unit is disposed inside the soft magnetic metal material of the magnetic flux connection unit or at a gap with the soft magnetic metal materials of the magnetic flux conversion module.

Optionally, in addition to the first magnetic flux conversion unit and the second magnetic flux conversion unit, the magnetic flux conversion module also comprises an enhanced magnetic flux conversion unit made of a high-permeability soft magnetic metal material. The enhanced magnetic flux conversion unit is superimposed on the first magnetic flux conversion unit and/or the second magnetic flux conversion unit in the Z-axis direction to further concentrate and amplify the magnetic field to be measured.

Optionally, the magnetic induction units are respectively formed by connecting one or more magnetoresistive sensitive elements in series and parallel. The magnetoresistive sensitive elements are any one of anisotropic magnetoresistors (AMR), giant magnetoresistors (GMR), and tunnel magnetoresistors (TMR). Optionally, the output module comprises an open-loop signal conditioning circuit, or a closed-loop signal conditioning circuit and a magnetic field feedback coil. The open-loop signal conditioning circuit performs conditioning, amplification, temperature compensation, and linearity correction on the differential voltage signal and then forms an output signal of the Z-axis magnetic field sensor. The closed-loop signal conditioning circuit, the magnetic field feedback coil, and the magnetic induction unit constitute a closed-loop magnetic field feedback structure. After the closed-loop signal conditioning circuit amplifies the differential voltage signal, the magnetic field feedback coil generates a feedback magnetic field to achieve dynamic magnetic field balance; and the feedback current in the magnetic field feedback coil is sampled to form an output signal of the Z-axis magnetic field sensor.

Optionally, the Z-axis magnetic field sensor further comprises lead pads and a mechanical support housing; and the Z-axis magnetic field sensor is manufactured using a single-chip integration process.

A second aspect of the present application provides a processing method for a Z -axis magnetic field sensor, and the processing method is used to process a Z-axis magnetic field sensor comprising a substrate, a magnetic flux conversion module, and a magnetic induction module; the magnetic induction module comprises at least two magnetic induction units; the magnetic flux conversion module comprises at least one first magnetic flux conversion unit and at least one second magnetic flux conversion unit; and the processing method for a Z -axis magnetic field sensor comprises: depositing an MR magnetoresistive thin film on the surface of the substrate and then processing to form the magnetic induction unit; depositing a passivation layer on the surface of the substrate on which the magnetic induction unit is deposited; wherein the passivation layer is used to protect the magnetic induction unit; forming one or more grooves spaced apart on the substrate along the X-axis direction, and depositing a soft magnetic metal material having a high magnetic permeability in the grooves to form the first magnetic flux conversion unit in the magnetic flux conversion module; forming one or more soft magnetic metal materials spaced apart above the passivation layer of the substrate by means of deposition and semiconductor microfabrication, to form the second magnetic flux conversion unit in the magnetic flux conversion module; the first magnetic flux conversion unit and the second magnetic flux conversion unit are evenly arranged on two sides of the magnetic induction unit; wherein the projections of the first magnetic flux conversion unit and the second magnetic flux conversion unit on the X-axis do not overlap or the overlapping portion is less than an overlap threshold; the overlap threshold is related to the measurement range of the magnetic field sensor; wherein the magnetic flux conversion module is used to modulate a magnetic field to be measured and generate a magnetic field component in the X-axis direction to form a target magnetic flux path; the magnetic induction unit is used to generate a differential voltage signal under the action of the target magnetic flux path; the plane on which the substrate is located is a plane formed by the X-axis and the Y-axis, the magnetic flux conversion module is disposed along the X-axis direction, and the plane perpendicular to the plane on which the substrate is located is the plane on which the Z-axis is located.

Optionally, the groove is formed on the substrate using a backside deep reactive ion etching (DRIE) process, and the groove opening is located on the surface of the substrate away from the MR magnetoresistive thin film; and after depositing the soft magnetic metal material, the chemical mechanical polishing (CMP) process is used for polishing.

Optionally, one or more soft magnetic metal materials spaced apart along the X-axis direction are deposited on the surface where the MR magnetoresistive thin film is located and/or on the substrate surface adjacent to the MR magnetoresistive thin film to form a magnetic flux connection unit.

Optionally, an enhanced magnetic flux conversion unit is superimposed along the Z-axis direction on the second magnetic flux conversion unit formed by depositing a soft magnetic metal material on the surface of the substrate away from the MR magnetoresistive thin film and/or on the surface on which the substrate MR magnetoresistive thin film is located.

Optionally, the MR magnetoresistive thin film comprises an anisotropic magnetoresistor (AMR), a giant magnetoresistor (GMR), or a tunnel magnetoresistor (TMR).

Optionally, the Z-axis magnetic field sensor adopts single-chip packaging, and is packaged into a single chip by means of wafer-level packaging (WLP) and through silicon via (TSV) processes to attach lead pads and circuits.

A third aspect of the present application provides a processing method for a Z -axis magnetic field sensor, and the processing method is used to process a Z-axis magnetic field sensor comprising a substrate, a magnetic flux conversion module, and a magnetic induction module; the magnetic induction module comprises at least two magnetic induction units; the magnetic flux conversion module comprises at least one first magnetic flux conversion unit and at least one second magnetic flux conversion unit; and the processing method for a Z -axis magnetic field sensor comprises: forming one or more soft magnetic metal materials spaced apart above the substrate by means of deposition and semiconductor microfabrication, to form the first magnetic flux conversion unit, using the chemical mechanical polishing (CMP) process to perform polishing, and depositing a passivation layer. Depositing an MR magnetoresistive thin film on the surface of the passivation layer, and processing to form the magnetic induction unit in the magnetic induction module by means of semiconductor patterned microfabrication; after depositing a passivation layer above the magnetic induction unit again, forming one or more soft magnetic metal materials spaced apart by means of deposition and semiconductor microfabrication above the passivation layer, to form the second magnetic flux conversion unit in the magnetic flux conversion module. The first magnetic flux conversion unit and the second magnetic flux conversion unit are evenly arranged on two sides of the magnetic induction unit; wherein the projections of the first magnetic flux conversion unit and the second magnetic flux conversion unit on the X-axis do not overlap or the overlapping portion is less than an overlap threshold; wherein the magnetic flux conversion module is used to modulate a magnetic field to be measured and generate a magnetic field component in the X-axis direction to form a target magnetic flux path; the magnetic induction unit is used to generate a differential voltage signal under the action of the target magnetic flux path; the plane on which the substrate is located is a plane formed by the X-axis and the Y-axis, the magnetic flux conversion module is disposed along the X-axis direction, and the plane perpendicular to the plane on which the substrate is located is the plane on which the Z-axis is located.

Optionally, a groove is formed on the substrate using a backside deep reactive ion etching (DRIE) process, and the groove opening is located on the surface of the substrate away from the MR magnetoresistive thin film; and after depositing the soft magnetic metal material, the chemical mechanical polishing (CMP) process is used for polishing.

Optionally, one or more soft magnetic metal materials spaced apart along the X-axis direction are deposited on the surface where the MR magnetoresistive thin film is located and/or on the substrate surface adjacent to the MR magnetoresistive thin film to form a magnetic flux connection unit.

Optionally, an enhanced magnetic flux conversion unit is superimposed along the Z-axis direction on the second magnetic flux conversion unit formed by depositing a soft magnetic metal material on the surface of the substrate away from the MR magnetoresistive thin film and/or on the surface on which the substrate MR magnetoresistive thin film is located.

Optionally, the MR magnetoresistive thin film comprises an anisotropic magnetoresistor (AMR), a giant magnetoresistor (GMR), or a tunnel magnetoresistor (TMR). Optionally, the Z-axis magnetic field sensor adopts single-chip packaging, and is packaged into a single chip by means of wafer-level packaging (WLP) and through silicon via (TSV) processes to attach lead pads and circuits.

A fourth aspect of the present application provides a processing method for a Z -axis magnetic field sensor, and the processing method is used to process a Z-axis magnetic field sensor comprising a substrate, a magnetic flux conversion module, and a magnetic induction module; the magnetic induction module comprises at least two magnetic induction units; the magnetic flux conversion module comprises at least one first magnetic flux conversion unit and at least one second magnetic flux conversion unit; the substrate comprises a first substrate and a second substrate; and the processing method for a Z -axis magnetic field sensor comprises: depositing an MR magnetoresistive thin film on the surface of the first substrate, then forming, by means of semiconductor patterned microfabrication, the magnetic induction unit in the magnetic induction module, and subsequently depositing a non-conductive passivation layer on the substrate to protect the magnetic induction unit. Forming one or more grooves spaced apart on the surface of the first substrate away from the MR magnetoresistive thin film by using the backside deep reactive ion etching (DRIE) process on the first substrate; depositing a soft magnetic metal material in the groove, and using the chemical mechanical polishing (CMP) process to perform polishing to form the first magnetic flux conversion unit in the magnetic flux conversion module. Using the same process flow for the second substrate as the one for the first substrate to form the magnetic induction unit and the second magnetic flux conversion unit, or not depositing an MR magnetoresistive thin film, the subsequent process flow being similar to the one for the first substrate, forming one or more grooves spaced apart by using the backside DRIE process, depositing a soft magnetic metal material, and then using the CMP process to form the second magnetic flux conversion unit.

Arranging the first substrate and the second substrate in an opposite manner along the Z-axis direction by means of the wafer-level packaging (WLP) process, and arranging the first magnetic flux conversion unit and the second magnetic flux conversion unit evenly on two sides of the magnetic induction unit; wherein the projections of the first magnetic flux conversion unit and the second magnetic flux conversion unit on the X-axis do not overlap or the overlapping portion is less than an overlap threshold; the overlap threshold is related to the measurement range of the magnetic field sensor. The MR magnetoresistive thin film is located in the X-axis direction at the position of spacing between the soft magnetic metal materials of the adjacent first magnetic flux conversion unit and second magnetic flux conversion unit. MR magnetoresistive thin films on the same substrate have the same sensitivity direction; in the case where the second substrate contains a magnetic induction unit, after the first substrate and the second substrate are disposed in an opposite manner along the Z-axis direction and packaged, the sensitivity directions of the first substrate magnetic induction unit and the second substrate magnetic induction unit are both parallel to the plane formed by the X-axis and the Y-axis.

Optionally, one or more soft magnetic metal materials spaced apart along the X-axis direction are further deposited on the surface where the MR magnetoresistive thin film is located and/or on the substrate surface adjacent to the MR magnetoresistive thin film to form a magnetic flux connection unit.

Optionally, an enhanced magnetic flux conversion unit containing a soft magnetic metal material with high magnetic permeability is further superimposed along the Z-axis direction on the second magnetic flux conversion unit formed by depositing a soft magnetic metal material on the surface of the substrate away from the MR magnetoresistive thin film and/or on the surface on which the substrate MR magnetoresistive thin film is located.

Optionally, the MR magnetoresistive thin film comprises an anisotropic magnetoresistor (AMR), a giant magnetoresistor (GMR), and a tunnel magnetoresistor (TMR).

Optionally, the Z-axis magnetic field sensor adopts single-chip packaging, and is packaged into a single chip by means of wafer-level packaging (WLP) and through silicon via (TSV) processes to attach lead pads and circuits.

The Z-axis magnetic field sensor provided in embodiments of the present application arranges a first magnetic induction unit between magnetic flux conversion modules along the Z-axis direction; wherein a magnetic field to be measured is twisted in the X-axis direction under the action of the magnetic flux conversion modules, and generates an X-axis magnetic field component at the location of the first magnetic induction unit to form a target magnetic flux path; the first magnetic induction unit generates a differential voltage signal under the action of the target magnetic flux path; and furthermore, the magnitude of the Z-axis magnetic field can be measured based on the differential voltage signal. Therefore, the Z-axis magnetic field sensor provided in the embodiments of the present application realizes the X-axis guidance of the magnetic circuit in the Z-axis direction, enhances the magnetic flux concentration effect and magnetic field uniformity, achieves higher magnetic field conversion efficiency, improves sensitivity, and solves the problems of low sensitivity, poor accuracy, and high noise of existing Z-axis magnetic field sensors.

### Brief Description of the Accompanying Drawings

FIG. 1 is a schematic diagram of a Z-axis magnetic field sensor and a processing method therefor provided in the embodiments of the present application;
FIG. 2 is a simulation diagram of a magnetic flux path of a Z-axis magnetic field sensor and a processing method therefor provided in the embodiments of the present application;
FIG. 3 shows simulation results of a magnetic field component in the X-axis direction according to the prior art;
FIG. 4 shows simulation results of a magnetic field component in the X-axis direction according to the present application;
FIG. 5 is a schematic diagram of another Z-axis magnetic field sensor and a processing method therefor provided in the embodiments of the present application;
FIG. 6 is a schematic diagram of a Z-axis magnetic field sensor superimposed with an enhanced magnetic flux conversion unit provided in the embodiments of the present application;
FIG. 7 is a schematic diagram of another Z-axis magnetic field sensor and a processing method therefor provided in the embodiments of the present application;
FIG. 8 is a schematic diagram of still another Z-axis magnetic field sensor and a processing method therefor provided in the embodiments of the present application;
FIG. 9 is a schematic diagram of still another Z-axis magnetic field sensor and a processing method therefor provided in the embodiments of the present application.

### Detailed Description of Specific Embodiments

The technical solutions in the embodiments of the present application will be described with reference to the accompanying drawings in the embodiments of the present application. For example, the flow charts and block diagrams in the accompanying drawings illustrate architecture, functionality, and operations of possible implementations of systems, methods, and computer program products according to various embodiments of the present invention. In this respect, each box in the flow charts or block diagrams may represent a module, program segment, or portion of code, which contains one or more executable instructions for implementing a specified logical function. It should also be noted that in some alternative implementations, the functions marked in the boxes may also occur in an order different from those marked in the accompanying drawings. For example, two consecutive boxes can actually be executed essentially in parallel, and sometimes they may also be executed in reverse order, depending on the functionality involved. It should also be noted that each box in a block diagram and/or flow chart, as well as combinations of boxes in a block diagram and/or flow chart, can be implemented using a dedicated hardware-based system that performs specified functions or actions, or using a combination of dedicated hardware and computer instructions. In addition, the functional modules in the various embodiments of the present invention can be integrated together to form an independent part, or each module can exist independently, or two or more modules can be integrated to form an independent part.

Magnetic sensors can measure physical parameters such as current, position, motion, and direction by sensing changes in magnetic field strength. For example, in current measurement, a magnetic sensor can be used to measure a current flowing through a conductor. By passing a wire through a magnetic sensor, a change in the magnetic field is generated nearby when a current flows through the wire. The magnetic sensor can detect this change and convert it into an electrical signal. In position and motion measurement, magnetic sensors can be used to detect the position and motion of an object. By placing a magnetic sensor between the object and a reference magnet, changes in the magnetic field can be measured, and the position and motion state of the object can be determined. Magnetic sensors can also be used to determine direction. For example, electronic compasses use magnetic sensors to detect the Earth's magnetic field and determine the direction of navigation devices based on the direction of the magnetic field.

The applicant discovered through research that this process usually involves the measurement of the Z-axis magnetic field, that is, the measurement of the magnetic field in the direction normal to the plane where the magnetic sensor is located. Currently, the measurement of the Z-axis magnetic field is achieved mainly through methods such as detector coils, Hall elements, or magnetoresistive elements. Detector coils have low spatial resolution, limited sensitivity, and limited frequency characteristics; Hall elements have low sensitivity, high power consumption, and poor temperature characteristics; unlike Hall elements, the sensitivity direction of typical magnetoresistive elements, including anisotropic magnetoresistive (AMR), giant magnetoresistive (GMR), and tunnel magnetoresistive (TMR) sensors, is in the in-plane direction, which limits applications of magnetoresistive elements in scenarios such as vertical magnetic field and triaxial vector magnetic field detection. In applications of electronic compasses and miniature triaxial magnetometers, due to the in-plane sensing characteristics of magnetoresistive sensors, chips with the sensitive directions along the in-plane X/Y axes need to be mounted vertically to sense the vertical magnetic field, which significantly increases the size of the packaged electronic compass, and affects the miniaturization and overall performance of the chips.

To adapt to applications of vertical magnetic field detection, current magnetoresistive sensors mainly employ the following methods:
(1) Vertical installation of magnetic field sensors with the in-plane sensitive directions, which can enable the detection of vertical magnetic fields, but will usually increase the size, resulting in inconvenience in application and affecting the use performance.
(2) TMR sensors with a vertical sensitive direction. However, the rate of change of magnetoresistance in the vertical sensitive direction is relatively low, which typically only reaches 20-40% and is far below the 250% level at room temperature in the in-plane sensitive direction. Meanwhile, vertically sensitive sensors have a relatively high saturation magnetic field that is typically around 1000 Oe. Due to these limitations, the sensitivity of the manufactured vertically sensitive sensors can be only around 0.1mV/V/Oe. Therefore, existing vertical sensitive sensors have deteriorated signal-to-noise ratio, and fail to fully leverage the performance advantages of magnetoresistive sensors.
(3) Measurement can be performed by using a soft magnetic sheet to bend and convert the magnetic field in the vertical Z-axis direction into a magnetic field in the in-plane X-axis and Y-axis directions. However, currently used magnetic flux concentration structures are usually one layer of long strip arrays of soft magnetic alloys deposited on a substrate, which results in uneven magnetic field distribution in the measurement direction, and makes it difficult to achieve high accuracy. Furthermore, low conversion efficiency can also lead to loss of sensitivity and high noise levels. Taking a TMR magnetoresistive sensor as an example, the converted chip sensitivity is about 0.1mV/V/Oe, and the corresponding background noise is two orders of magnitude higher than that of a TMR in the in-plane sensing direction.

Therefore, the present application provides a Z-axis magnetic field sensor, a fabrication method, and an electronic device; wherein the Z-axis magnetic field sensor realizes the X-axis guidance of the magnetic circuit in the Z-axis direction by setting up a special structure of a magnetic flux conversion module and a magnetic induction unit, enhances the magnetic flux concentration effect and magnetic field uniformity, achieves higher magnetic field conversion efficiency, improves sensitivity, and solves the problems of low sensitivity, poor accuracy, and high noise of existing Z-axis magnetic field sensors.

### Embodiment I

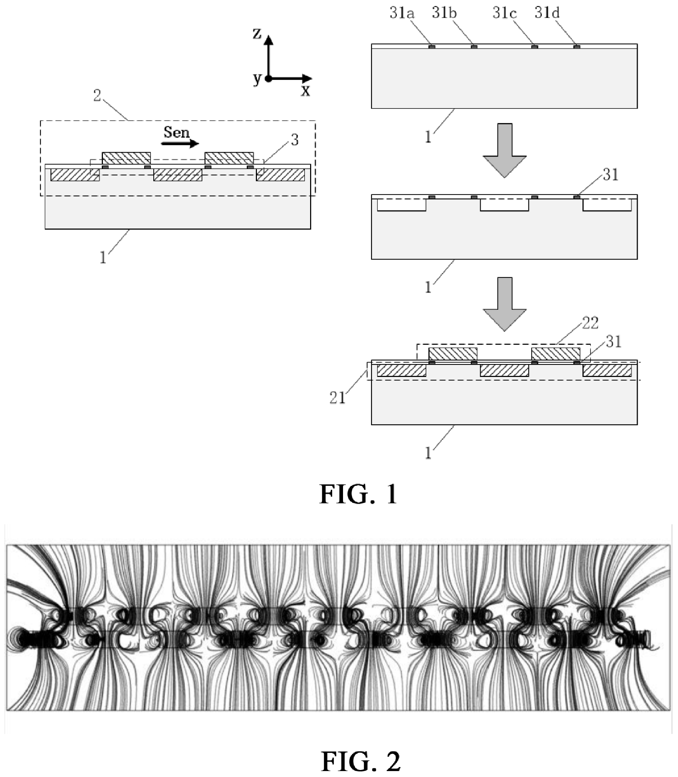

FIG. 1 is a schematic diagram of a Z-axis magnetic field sensor and a processing method therefor provided in the embodiments of the present application; as shown in FIG. 1, the Z-axis magnetic field sensor provided in this embodiment comprises: a substrate 1, a magnetic flux conversion module 2, a magnetic induction module 3, and an output module.

The cross section shown in FIG. 1 is located in the XZ plane, the magnetic flux conversion module 2 comprises a first magnetic flux conversion unit 21 and a second magnetic flux conversion unit 22 made of a high-permeability soft magnetic metal material, and the magnetic induction unit 31 in the magnetic induction module 3 adopts a tunnel magnetoresistor (TMR) deposited on the substrate 1.

The first magnetic flux conversion unit 21 is located in the groove of the substrate 1, and the second magnetic flux conversion unit 22 is located above the substrate 1; as shown in FIG. 1, soft magnetic metal materials of the first magnetic flux conversion unit 21 and the second magnetic flux conversion unit 22 are spaced apart in the X-axis direction, their projections in the Z-axis direction do not overlap, and the magnetic induction units 31 are distributed at the position of spacing with the sensitivity directions all being the positive X-axis direction.

In the embodiments of the present application, the projections of the first magnetic flux conversion unit and the second magnetic flux conversion unit on the X-axis do not overlap or the overlapping portion is less than an overlap threshold, and the overlap threshold is related to the measurement range of the magnetic field sensor.

Please refer to FIG. 2 based on FIG. 1. FIG. 2 is a simulation diagram of a magnetic flux path of a Z-axis magnetic field sensor provided in the embodiments of the present application. When performing Z-axis magnetic field detection, the magnetic flux conversion module 2 selects different numbers of soft magnetic alloy structures of the first magnetic flux conversion unit 21 and the second magnetic flux conversion unit 22 according to the actual application. For example, the magnetic flux conversion module comprising three first magnetic flux conversion units 21 and two second magnetic flux conversion units 22 is taken as an example for description. A magnetic field to be measured is concentrated and amplified by the soft magnetic metal materials of the first magnetic flux conversion unit 21 and the second magnetic flux conversion unit 22 to form a magnetic circuit. Since the soft magnetic metal materials are distributed at intervals, the magnetic circuit will be twisted in the X -axis direction as shown in FIG. 2 when it is converted between the first magnetic flux conversion unit 21 and the second magnetic flux conversion unit 22. An X-axis magnetic field component is generated at the location of the magnetic induction unit 31.

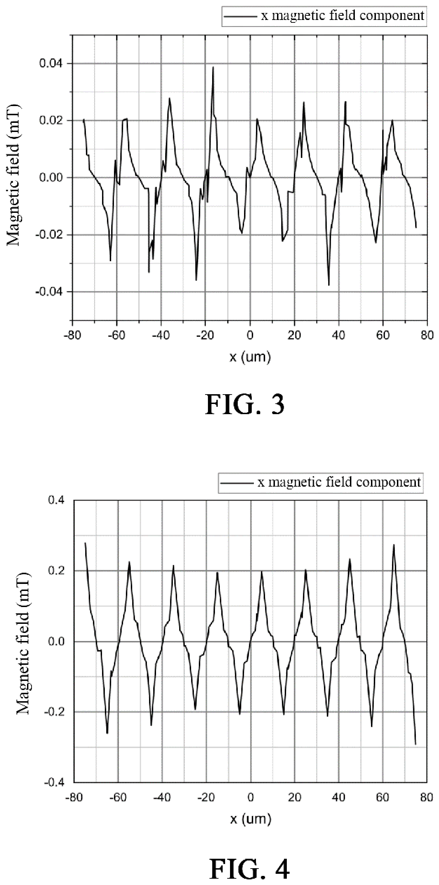

FIG. 3 shows simulation results of a magnetic field component in the X-axis direction according to the prior art; as shown in FIG. 3, the prior art uses a single-layer array of long strip soft magnetic alloy structures, which is equivalent to containing only the first magnetic flux conversion unit or the second magnetic flux conversion unit of the present invention. The single-layer array of long strip soft magnetic alloy structures in the prior art is used for simulation on a plane where the first magnetic flux conversion unit 21 is located. FIG. 3 shows results of the magnetic field component in the X-axis direction of the horizontal line where the magnetic induction unit 31 is located after simulating the single-layer array of long strip soft magnetic alloy structures in the prior art applied with a Z-axis magnetic field of 0.1mT. As can be seen from FIG. 3, although the prior art can convert the Z-axis magnetic field into an X-axis magnetic field component that can be measured differentially, its magnetic field distribution is not uniform, which easily causes zero-point drift and makes it difficult to achieve high precision. Moreover, the deposition method according to the prior art is limited by the thickness of the soft magnetic metal material. The X-axis magnetic field component generated after the Z-axis magnetic field is concentrated and converted is small, resulting in serious sensitivity loss and high device noise.

Please refer to FIG. 4, which shows simulation results of the magnetic field component in the X-axis direction provided in the present application; the present application uses the first magnetic flux conversion unit 21 and the second magnetic flux conversion unit 22 arranged alternately to perform magnetic flux conversion, and can combine the backside deep reactive ion etching (DRIE) process or superimpose an enhanced magnetic flux conversion unit to increase the thickness of the soft magnetic metal material and enhance the magnetic flux concentration effect. FIG. 4 shows results of the magnetic field component in the X-axis direction of the horizontal line where the magnetic induction unit 31 is located after simulating a two-layer spaced soft magnetic metal material structure (containing both the first magnetic flux conversion unit 21 and the second magnetic flux conversion unit 22) of the present invention applied with a Z-axis magnetic field of 0.1 mT. As can be seen from FIG. 4, due to the magnetic circuit guiding effect of the magnetic flux conversion module 2 structure in the embodiments of the present application, the curve shown in FIG. 4 is smoother and has a more uniform peak value than that in FIG. 3, and it also has higher sensitivity and lower noise.

Please continue to refer to FIG. 1. For the embodiment shown in FIG. 1, the magnetic induction module 3 comprises four magnetic induction units 31 located in the Z-axis direction between the plane formed by the X-axis and Y-axis of the first magnetic flux conversion unit 21 and the plane formed by the X-axis and Y-axis of the second magnetic flux conversion unit 22, and located in the X-axis direction at the position of spacing between the soft magnetic metal materials of the adjacent first magnetic flux conversion unit 21 and second magnetic flux conversion unit 22, namely magnetic induction units 31a, 31b, 31c, and 31d. All magnetic induction units 31 are located in the plane formed by the same X-axis and Y-axis in the Z-axis direction and have the same sensitivity direction, which is the positive X-axis direction. When a magnetic field to be measured is in the positive Z-axis direction, the converted X-axis magnetic field component in FIG. 1 points to the right (the positive X direction) at the positions of the magnetic induction units 31a and 31c, and to the left (the negative X direction) at the positions of the magnetic induction units 31b and 31d; since the sensitivity directions of the magnetic induction units 31 are all in the positive X direction, the resistance values of the magnetic induction units 31a and 31c decrease, while the resistance values of the magnetic induction units 31b and 31d increase.

Therefore, the magnetic induction module 3 can use a push-pull full-bridge structure to sense the magnetic field of the magnetic flux conversion module 2 and generate a differential voltage signal. The output module in this embodiment adopts an open-loop signal conditioning circuit to perform conditioning amplification, temperature compensation, and linearity correction on the differential voltage signal and then form an output signal of the Z-axis magnetic field sensor. Since the magnetic induction units 31 in this embodiment all have the same sensitivity direction, they can be combined with lead pads and mechanical support housing, and a single-chip integrated fabrication process may be used.

The following is a processing method corresponding to the Z-axis magnetic field sensor provided in this embodiment. As shown in FIG. 1, a substrate 1 is provided, a TMR magnetoresistive thin film is deposited on the surface of the substrate 1, magnetic induction units 31a, 31b, 31c, and 31d are formed by means of semiconductor patterned microfabrication, and they are connected to form a push-pull full-bridge structure. Then, a non-conductive passivation layer is deposited on the substrate 1 to protect the magnetic induction unit 31. Grooves spaced apart are etched on the substrate 1, and a soft magnetic metal material having a high magnetic permeability is deposited in the grooves to form the first magnetic flux conversion unit 21. The soft magnetic metal material is further deposited above the passivation layer of the substrate 1, and another layer of the metal soft magnetic structure spaced apart from the soft magnetic metal material of the first magnetic flux conversion unit 21 is formed by means of semiconductor microfabrication, to form the second magnetic flux conversion unit 22. There are regions where soft magnetic metal materials of the first magnetic flux conversion unit 21 and the second magnetic flux conversion unit 22 are spaced apart in the X-axis direction, and in such regions, projections of the soft magnetic metal materials of adjacent first magnetic flux conversion unit 21 and second magnetic flux conversion unit 22 in the Z-axis direction do not overlap. The TMR magnetoresistive thin film is located in the X-axis direction at the position of spacing between the soft magnetic metal materials of adjacent first magnetic flux conversion unit 21 and second magnetic flux conversion unit 22. This embodiment can be combined with lead pads and mechanical support housing to form a single chip.

Therefore, according to the Z-axis magnetic field sensor and the processing method therefor provided in this embodiment, two layers of the soft magnetic metal material are deposited on the surface of the substrate 1 and on the interior of the groove to form a soft magnetic metal material structure with two layers of the first magnetic flux conversion unit 21 and the second magnetic flux conversion unit 22 spaced apart and the projections thereof in the Z-axis direction not overlap, thereby realizing the X-axis guidance of the magnetic circuit in the Z-axis direction, enhancing the magnetic flux concentration effect and magnetic field uniformity, achieving higher magnetic field conversion efficiency, improving sensitivity, and solving the problems of low sensitivity, poor accuracy, and high noise of existing Z-axis magnetic field sensors. Meanwhile, since the present application can simultaneously generate magnetic field components in the positive and negative X-axis directions, the magnetic induction unit can achieve push-pull full-bridge measurement using only the same sensitivity direction. Compared with the prior art that uses magnetic induction units with multiple sensitivity directions, it simplifies the fabrication steps, improves sensitivity consistency, reduces temperature drift, enhances stability, and enables single-chip fabrication.

### Embodiment II

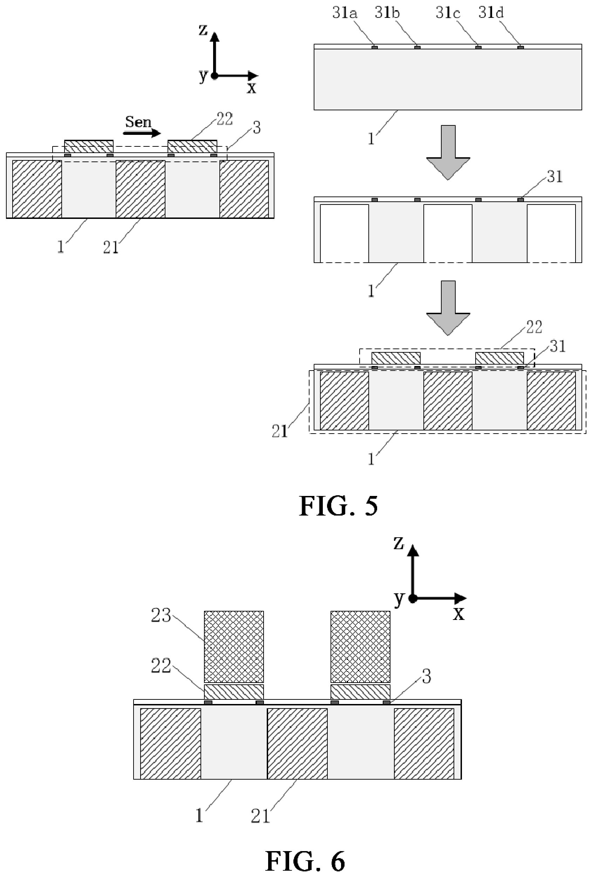

Please refer to FIG. 5, which is a schematic diagram of another Z-axis magnetic field sensor and a processing method therefor provided in the embodiments of the present application; the Z-axis magnetic field sensor provided in this embodiment comprises: a substrate 1, a magnetic flux conversion module 2, a magnetic induction module 3, and an output module.

As shown in FIG. 5, the cross section of the Z-axis magnetic field sensor is located in the XZ plane, and the magnetic flux conversion module 2 comprises a first magnetic flux conversion unit 21 and a second magnetic flux conversion unit 22 made of a high-permeability soft magnetic metal material. The magnetic induction unit 31 in the magnetic induction module 3 adopts a giant magnetoresistor (GMR) deposited on the substrate 1. The first magnetic flux conversion unit 21 is located in the groove of the substrate 1, and the second magnetic flux conversion unit 22 is located above the substrate 1. As shown in FIG. 5, the groove opening of the substrate 1 is located on the surface of the substrate 1 away from the magnetoresistive thin film of the magnetic induction unit 31, and the deep reactive ion etching (DRIE) process is used for processing, so that the thickness of the soft magnetic metal material deposited in the groove can be significantly greater than the thickness achieved by a process of direct deposition on the surface of the substrate 1. The soft magnetic metal materials of the first magnetic flux conversion unit 21 and the second magnetic flux conversion unit 22 are spaced apart in the X-axis direction, and the projections thereof in the Z-axis direction do not overlap. The magnetic induction module 3 comprises four magnetic induction units 31 located in the Z-axis direction between the plane formed by the X-axis and Y-axis of the first magnetic flux conversion unit 21 and the plane formed by the X-axis and Y-axis of the second magnetic flux conversion unit 22, and located in the X-axis direction at the position of spacing between the soft magnetic metal materials of adjacent first magnetic flux conversion unit 21 and second magnetic flux conversion unit 22, and the sensitivity directions of the magnetic induction units 31a, 31b, 31c, and 31d are all in the positive X-axis direction.

Similarly, taking a magnetic field to be measured being in the positive Z-axis direction as an example, the soft magnetic metal materials of the first magnetic flux conversion unit 21 and the second magnetic flux conversion unit 22 concentrate and amplify the magnetic field to be measured. When the magnetic circuit is converted between the first magnetic flux conversion unit 21 and the second magnetic flux conversion unit 22, it is twisted in the X-axis direction. The converted X-axis magnetic field component points to the right at the positions of the magnetic induction units 31a and 31c, and to the left at the positions of the magnetic induction units 31b and 31d. The resistance values of the magnetic induction units 31a and 31c decrease, while the resistance values of the magnetic induction units 31b and 31d increase. Therefore, by connecting the magnetic induction units 31a, 31b, 31c, and 31d and a reference resistor in series and parallel, the magnetic induction module 3 can use a differential full-bridge structure to sense the magnetic field of the magnetic flux conversion module 2 and generate a differential voltage signal. The output module in this embodiment adopts an open-loop signal conditioning circuit to perform conditioning amplification, temperature compensation, and linearity correction on the differential voltage signal and then form an output signal of the Z-axis magnetic field sensor.

The following is a processing method corresponding to the Z-axis magnetic field sensor provided in this embodiment. As shown in FIG. 5, a substrate 1 is provided, a GMR magnetoresistive thin film is deposited on the surface of the substrate 1, magnetic induction units 31a, 31b, 31c, and 31d and a reference resistor are formed by means of semiconductor patterned microfabrication, and they are connected to form a differential full-bridge structure. A non-conductive passivation layer is deposited on the substrate 1 to protect the magnetic induction unit 31. Grooves spaced apart are formed on the surface of the substrate 1 away from the GMR magnetoresistive thin film by using the backside deep reactive ion etching (DRIE) process; a soft magnetic metal material is deposited in the groove using a process such as electroplating and electroless plating, and is polished using the chemical mechanical polishing (CMP) process to form the first magnetic flux conversion unit 21 in the magnetic flux conversion module 2. The soft magnetic metal material is further deposited above the passivation layer of the surface of the substrate 1 where the GMR magnetoresistive thin film is located, and another layer of the metal soft magnetic structure spaced apart from the soft magnetic metal material of the first magnetic flux conversion unit 21 is formed by means of semiconductor microfabrication, to form the second magnetic flux conversion unit 22. There are regions where soft magnetic metal materials of the first magnetic flux conversion unit 21 and the second magnetic flux conversion unit 22 are spaced apart in the X-axis direction, and in such regions, projections of the soft magnetic metal materials of adjacent first magnetic flux conversion unit 21 and second magnetic flux conversion unit 22 in the Z-axis direction do not overlap. The GMR magnetoresistive thin film is located in the X-axis direction at the position of spacing between the soft magnetic metal materials of adjacent first magnetic flux conversion unit 21 and second magnetic flux conversion unit 22.

Therefore, this embodiment introduces the backside deep reactive ion etching (DRIE) process, which increases the groove depth and significantly increases the thickness of the soft magnetic metal material of the first magnetic flux conversion unit 21. Thus, based on the first embodiment, the magnetic flux concentration effect and conversion are further enhanced, the sensitivity is further improved, and it helps reduce the sensor noise.

In addition, to further enhance the magnetic flux concentration effect and improve sensitivity, the present application also proposes an enhanced magnetic flux conversion unit 23. The enhanced magnetic flux conversion unit 23 contains a high-permeability soft magnetic metal material, which can be superimposed on the upper or lower surface of an existing Z-axis magnetic field sensor along the Z-axis direction based on Embodiment I and Embodiment II, to further amplify the magnetic field to be measured. According to its processing method, an enhanced magnetic flux conversion unit containing a soft magnetic metal material with high magnetic permeability is superimposed along the Z-axis direction on the second magnetic flux conversion unit formed by depositing a soft magnetic metal material on the surface of the substrate away from the MR magnetoresistive thin film or on the surface on which the substrate MR magnetoresistive thin film is located. For example, please refer to FIG. 6, which is a schematic diagram of the enhanced magnetic flux conversion unit superimposed on the Z-axis magnetic field sensor provided in the embodiment of the present application; as shown in FIG. 6, the upper surface of the embodiment shown in FIG. 5 can be superimposed, and the enhanced magnetic flux conversion unit 23 is superimposed on the second magnetic flux conversion unit 22 formed by depositing a soft magnetic metal material. The enhanced magnetic flux conversion unit 23 can be connected to the Z-axis magnetic field sensor by means of external bonding, which mainly plays the role of enhancing magnetic flux concentration; it can also further regulate the magnetic field distribution, solve the thickness limitation problem of the soft magnetic metal material caused by the process limitations, enhance the X magnetic field component after conversion, and make the magnetic field distribution in the Z-axis direction more uniform.

### Embodiment III

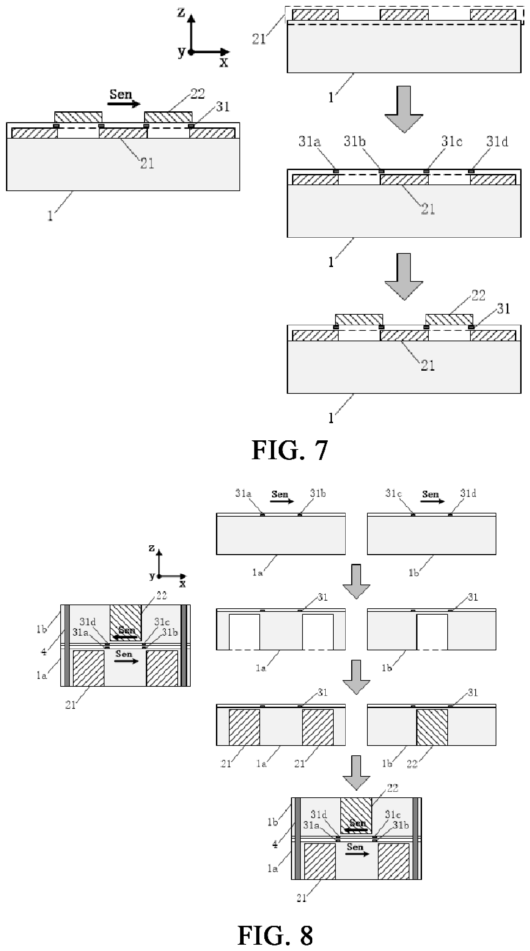

Please refer to FIG. 7, which is a schematic diagram of another Z-axis magnetic field sensor and a processing method therefor provided in the embodiments of the present application; the Z-axis magnetic field sensor provided in this embodiment comprises: a substrate 1, a magnetic flux conversion module 2, a magnetic induction module 3, and an output module.

As shown in FIG. 7, the cross section of the Z-axis magnetic field sensor is located in the XZ plane, and the magnetic flux conversion module 2 comprises a first magnetic flux conversion unit 21 and a second magnetic flux conversion unit 22 made of a high-permeability soft magnetic metal material. The first magnetic flux conversion unit 21 is located above the substrate 1. The magnetic induction unit 31 in the magnetic induction module 3 adopts an anisotropic magnetoresistor (AMR) deposited above the first magnetic flux conversion unit 21; and the second magnetic flux conversion unit 22 is located above the magnetic induction unit 31. As shown in FIG. 7, soft magnetic metal materials of the first magnetic flux conversion unit 21 and the second magnetic flux conversion unit 22 are located on the same side of the substrate 1 and are spaced apart in the X-axis direction; and projections of the soft magnetic metal materials at edges of intervals of the first magnetic flux conversion unit 21 and the second magnetic flux conversion unit 22 in the Z-axis direction partially overlap. The magnetic induction module 3 comprises four magnetic induction units 31 located in the Z-axis direction between the plane formed by the X-axis and Y-axis of the first magnetic flux conversion unit 21 and the plane formed by the X-axis and Y-axis of the second magnetic flux conversion unit 22, and located in the X-axis direction at the position of spacing between the soft magnetic metal materials of adjacent first magnetic flux conversion unit 21 and second magnetic flux conversion unit 22, and the sensitivity directions of the magnetic induction units 31a, 31b, 31c, and 31d are all in the positive X-axis direction.

Similarly, taking a magnetic field to be measured being in the positive Z-axis direction as an example, the converted X-axis magnetic field component points to the right at the positions of the magnetic induction units 31a and 31c, and to the left at the positions of the magnetic induction units 31b and 31d. The resistance values of the magnetic induction units 31a and 31c decrease, while the resistance values of the magnetic induction units 31b and 31d increase. Therefore, it is feasible to select some of the magnetic induction units 31 and a reference resistor to form a differential half-bridge structure to sense the magnetic field of the magnetic flux conversion module 2 and generate a differential voltage signal.

The output module in this embodiment adopts a closed-loop signal conditioning circuit and a magnetic field feedback coil. The closed-loop signal conditioning circuit, the magnetic field feedback coil, and the magnetic induction unit 31 constitute a closed-loop magnetic field feedback structure; after the closed-loop signal conditioning circuit amplifies the differential voltage signal, the magnetic field feedback coil generates a feedback magnetic field to achieve dynamic magnetic field balance; and the feedback current in the magnetic field feedback coil is sampled to form an output signal of the Z-axis magnetic field sensor. Depending on the actual situation, the magnetic field feedback coil can be positioned to be a coil that wraps in-plane on the plane formed by the X-axis and Y-axis on the upper or lower surface of the substrate 1, or a coil that wraps around the Z-axis direction on all four sides of the substrate 1. In addition, any upper or lower surface of the first magnetic flux conversion unit 21, the magnetic induction unit 31, and the second magnetic flux conversion unit 22 may also be selected as the position to arrange the coil that wraps in-plane on the plane formed by the X-axis and Y-axis, and since the magnetic field feedback coil is an existing basic technology, it will not be described in detail. In this embodiment, the magnetic field feedback coil is positioned on the upper surface of the magnetic induction unit 31 (the lower surface of the second magnetic flux conversion unit 22).

The following is a processing method corresponding to the Z-axis magnetic field sensor provided in this embodiment. Please refer to FIG. 7, which is a schematic diagram of another Z-axis magnetic field sensor and a processing method therefor provided in the embodiments of the present application. The processing method comprises: providing a substrate 1, forming soft magnetic metal materials spaced apart above the substrate 1 by means of deposition and semiconductor microfabrication, to form the first magnetic flux conversion unit 21. For the surface of the first magnetic flux conversion unit 21, the chemical mechanical polishing (CMP) process is used for polishing, and a passivation layer is deposited, an AMR magnetoresistive thin film is deposited on the surface of the passivation layer, magnetic induction units 31a, 31b, 31c, and 31d and a reference resistor are formed by means of semiconductor patterned microfabrication, and they are connected to form a differential half-bridge structure. After a passivation layer is further deposited above the magnetic induction unit 31 to protect the magnetoresistive thin film, a magnetic field feedback coil is fabricated, and then another layer of the metal soft magnetic structure spaced apart from the soft magnetic metal material of the first magnetic flux conversion unit 21 is formed by means of deposition and semiconductor microfabrication, to form the second magnetic flux conversion unit 22. There are regions where soft magnetic metal materials of the first magnetic flux conversion unit 21 and the second magnetic flux conversion unit 22 are spaced apart in the X-axis direction, and in such regions, projections of the soft magnetic metal materials of adjacent first magnetic flux conversion unit 21 and second magnetic flux conversion unit 22 in the Z-axis direction partially overlap with the overlapping length shorter than 1/2 of the length of the soft magnetic metal materials of adjacent first magnetic flux conversion unit 21 and second magnetic flux conversion unit 22. The AMR magnetoresistive thin film is located in the X-axis direction at the position of spacing between the soft magnetic metal materials of adjacent first magnetic flux conversion unit 21 and second magnetic flux conversion unit 22.

In summary, this embodiment deposits two layers of soft magnetic metal material directly on the same surface of the substrate 1, instead of using a groove process, to form a soft magnetic metal material structure in which two layers of the first magnetic flux conversion unit 21 and the second magnetic flux conversion unit 22 are spaced apart and their projections overlap in the Z-axis direction. Compared with other embodiments that require etching on the substrate 1, this reduces the complexity of the operation steps and facilitates production. In addition, this embodiment also adopts closed-loop negative feedback, thus featuring high accuracy and good linearity.

### Embodiment IV

Please refer to FIG. 8, which is a schematic diagram of still another Z-axis magnetic field sensor and a processing method therefor provided in the embodiments of the present application the present invention; the Z-axis magnetic field sensor provided in this embodiment comprises: a substrate 1, a magnetic flux conversion module 2, a magnetic induction module 3, and an output module.

As shown in FIG. 8, the cross section of the Z-axis magnetic field sensor is located in the XZ plane. In this embodiment, the substrate 1 adopts a first substrate 1a and a second substrate 1b, the magnetic flux conversion module 2 comprises a first magnetic flux conversion unit 21 and a second magnetic flux conversion unit 22 made of a high-permeability soft magnetic metal material, and the magnetic induction unit 31 in the magnetic induction module 3 adopts a tunnel magnetoresistor (TMR) deposited on the first substrate 1a and the second substrate 1b. The first magnetic flux conversion unit 21 is located in the groove of the first substrate 1a, and the second magnetic flux conversion unit 22 is located in the groove of the second substrate 1b. As shown in FIG. 8, the groove openings of the first substrate 1a and the second substrate 1b are located on the respective surfaces of the first substrate 1a and the second substrate 1b away from the magnetoresistive thin film thereof, and the deep reactive ion etching (DRIE) process is used to increase the groove depth and the deposition thickness of the soft magnetic metal material in the grooves. The soft magnetic metal materials of the first magnetic flux conversion unit 21 and the second magnetic flux conversion unit 22 are spaced apart in the X-axis direction, and the projections thereof in the Z-axis direction do not overlap. The magnetic induction units 31a and 31b are located on the first substrate 1a, and the magnetic induction units 31c and 31d are located on the second substrate 1b.

By means of a single-chip packaging process and through wafer-level advanced packaging (WLP) and through silicon via (TSV) process, lead pads and circuits are attached, the first substrate 1a and the second substrate 1b are arranged in an opposite manner with respect to the plane where a tunnel magnetoresistor (TMR) is located for packaging to form a single chip, and the magnetic induction units 31a, 31b, 31c, and 31d are all located at the position of spacing between the soft magnetic metal materials. After packaging, the magnetic induction units 31a, 31b, 31c, and 31d are located in the Z-axis direction between the plane formed by the X-axis and Y-axis of the first magnetic flux conversion unit 21 and the plane formed by the X-axis and Y-axis of the second magnetic flux conversion unit 22, and also located between the first substrate 1a and the second substrate 1b. Depending on the different directions selected in the plane formed by the X-axis and Y-axis when the first substrate 1a and the second substrate 1b are arranged in an opposite manner along the Z axis for packaging, the sensitivity direction of the magnetic induction units 31a and 31b and the sensitivity direction of the magnetic induction units 31c and 31d after packaging are correspondingly different. In this embodiment, the sensitivity direction of the first planar magnetic induction units 31a and 31b after packaging is the positive X direction, and the sensitivity direction of the second planar magnetic induction units 31c and 31d is the negative X direction; the magnetic induction units 31a and 31d are located at the same position of spacing, and the magnetic induction units 31b and 31c are located at the same position of spacing.

Taking a magnetic field to be measured being in the positive Z-axis direction as an example, the soft magnetic metal materials of the first magnetic flux conversion unit 21 and the second magnetic flux conversion unit 22 concentrate and amplify the magnetic field to be measured. When the magnetic circuit is converted between the first magnetic flux conversion unit 21 and the second magnetic flux conversion unit 22, it is twisted in the X-axis direction. The converted X-axis magnetic field component points to the right at the positions of the magnetic induction units 31a and 31d, and to the left at the positions of the magnetic induction units 31b and 31c. Since the sensitivity direction of the first planar magnetic induction units 31a and 31b after packaging points to the right (the positive X direction), and the sensitivity direction of the second planar magnetic induction units 31c and 31d points to the left (the negative X direction), the resistance values of the magnetic induction units 31a and 31c decrease, while the resistance values of the magnetic induction units 31b and 31d increase. Therefore, it is feasible to select the magnetic induction units 31a and 31d or the magnetic induction units 31b and 31c at the same position of spacing to form a push-pull half-bridge structure to sense the magnetic field of the magnetic flux conversion module 2 and generate a differential voltage signal. The output module in this embodiment adopts an open-loop signal conditioning circuit to perform conditioning amplification, temperature compensation, and linearity correction on the differential voltage signal and then form an output signal of the Z-axis magnetic field sensor.

The following is a processing method corresponding to the Z-axis magnetic field sensor provided in this embodiment. Please continue to refer to FIG. 8, the first substrate 1a and the second substrate 1b are provided, a TMR magnetoresistive thin film is deposited on the surfaces of the first substrate 1a and the second substrate 1b, respectively, and the magnetic induction units 31a, 31b, 31c, and 31d are formed by means of semiconductor patterned microfabrication. The magnetic induction units 31a and 31b are located on the first substrate 1a, and the magnetic induction units 31c and 31d are located on the second substrate 1b. A non-conductive passivation layer is deposited on the first substrate 1a and the second substrate 1b to protect the magnetic induction unit 31. A groove is formed on the respective surfaces of the first substrate 1a and the second substrate 1b away from the TMR magnetoresistive thin film using the backside deep reactive ion etching (DRIE) process, the soft magnetic metal material is deposited and filled in the grooves, and the chemical mechanical polishing (CMP) process is used for polishing to respectively form the first magnetic flux conversion unit 21 and the second magnetic flux conversion unit 22 in the magnetic flux conversion module 2. By means of a single-chip packaging process and through wafer-level advanced packaging (WLP) and through silicon via (TSV) processes, the first substrate 1a and the second substrate 1b are arranged in an opposite manner with respect to the plane where the TMR magnetoresistive thin film is located for packaging, copper conductors 4 are used to pass through the through silicon vias to form circuit connections, thereby forming a push-pull half-bridge structure, and lead pads and circuits are attached and packaged into a single chip. After the packaging, there are regions where soft magnetic metal materials of the first magnetic flux conversion unit 21 and the second magnetic flux conversion unit 22 are spaced apart in the X-axis direction, and in such regions, projections of the soft magnetic metal materials of adjacent first magnetic flux conversion unit 21 and second magnetic flux conversion unit 22 in the Z-axis direction do not overlap. The packaged TMR magnetoresistive thin film is located in the X-axis direction at the position of spacing between the soft magnetic metal materials of adjacent first magnetic flux conversion unit 21 and second magnetic flux conversion unit 22.

In summary, this embodiment arranges two substrates containing magnetic induction units in an opposite manner, so that the sensitivity directions of the magnetic induction units located on the first and second planes are opposite. It also uses single-chip packaging, in combination with the backside deep reactive ion etching (DRIE) process, to achieve a significant increase in sensitivity amplification based on small volume. It has the advantages of stable structure, high precision, and low noise.

### Embodiment V

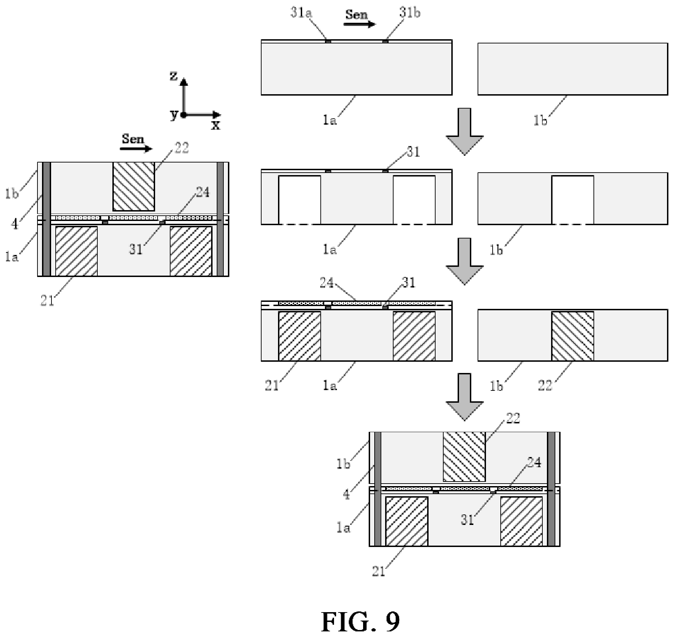

Please refer to FIG. 9, which is a schematic diagram of still another Z-axis magnetic field sensor and a processing method therefor provided in the embodiments of the present invention. The Z-axis magnetic field sensor provided in this embodiment comprises: a substrate 1, a magnetic flux conversion module 2, a magnetic induction module 3, and an output module.

As shown in FIG. 9, the cross section of the Z-axis magnetic field sensor is located in the XZ plane. In this embodiment, the substrate 1 adopts a first substrate 1a and a second substrate 1b, the magnetic flux conversion module 2 comprises a first magnetic flux conversion unit 21, a second magnetic flux conversion unit 22, and a magnetic flux connection unit 24 made of a high-permeability soft magnetic metal material, and the magnetic induction unit 31 in the magnetic induction module 3 adopts a tunnel magnetoresistor (TMR) deposited on the first substrate 1a. The first magnetic flux conversion unit 21 is located in the groove of the first substrate 1a, and the second magnetic flux conversion unit 22 is located in the groove of the second substrate 1b. As shown in FIG. 9, the groove opening of the first substrate 1a is located on the surface away from the magnetoresistive thin film thereof, and the deep reactive ion etching (DRIE) process is used for the first substrate 1a and the second substrate 1b to increase the deposition thickness of the soft magnetic metal material in the grooves. The soft magnetic metal materials of the first magnetic flux conversion unit 21 and the second magnetic flux conversion unit 22 are spaced apart in the X-axis direction, and the projections thereof in the Z-axis direction do not overlap. The magnetic induction units 31a and 31b are located on the first substrate 1a, and their sensitivity directions are both in the X-axis direction.

In addition, in this embodiment, the magnetic flux connection unit 24 is deposited on the plane above the magnetic induction unit 31, the magnetic flux connection unit 24 uses a soft magnetic metal material with high magnetic permeability, which is spaced apart in the X-axis direction, and the projections of the magnetic induction units 31a and 31b in the Z-axis direction are located inside the soft magnetic metal material of the magnetic flux connection unit 24 (at the intervals).

By means of a single-chip packaging process and through wafer-level advanced packaging (WLP) and through silicon via (TSV) process, the plane where the tunnel magnetoresistor (TMR) of the first substrate 1a is located and the surface of the second substrate 1b with no groove opening are arranged in an opposite manner for packaging, and the projections of the magnetic induction units 31a and 31b in the Z-axis direction are located at the position of spacing between the soft magnetic metal materials of the first magnetic flux conversion unit 21 and the second magnetic flux conversion unit 22. As shown in FIG. 9, after packaging, the magnetic induction units 31a and 31b in this embodiment are located in the Z-axis direction between the plane formed by the X-axis and Y-axis of the first magnetic flux conversion unit 21 and the plane formed by the X-axis and Y-axis of the second magnetic flux conversion unit 22, and also located between the first substrate 1a and the second substrate 1b; moreover, the projections in the Z-axis direction are not only located inside the soft magnetic metal material of the magnetic flux connection unit 24 (at the intervals), but also located at gaps between the soft magnetic material of the magnetic flux connection unit 24 and the soft magnetic materials of the first magnetic flux conversion unit 21 and the second magnetic flux conversion unit 22.

It should be noted that the magnetic flux connection unit 24 may be deposited on the first substrate 1a and may also be deposited on the second substrate 1b; the plane where the magnetic flux connection unit 24 is located is located between the plane formed by the X-axis and Y-axis of the first magnetic flux conversion unit 21 and the plane formed by the X-axis and Y-axis of the second magnetic flux conversion unit 22; and the projection of the soft magnetic metal material of the magnetic flux connection unit 24 in the Z-axis direction may partially overlap or may not overlap with the soft magnetic metal materials of the first magnetic flux conversion unit 21 and the second magnetic flux conversion unit 22. As shown in FIG. 9, this embodiment adopts a partially overlapping structure. Taking a magnetic field to be measured being in the positive Z-axis direction as an example, the soft magnetic metal materials of the first magnetic flux conversion unit 21 and the second magnetic flux conversion unit 22 concentrate and amplify the magnetic field to be measured. When the magnetic circuit is twisted to generate an X-axis magnetic field component, the magnetic flux connection unit 24 distributed along the X-axis direction connects the magnetic flux paths of the first magnetic flux conversion unit 21 and the second magnetic flux conversion unit 22, and concentrates and guides the magnetic flux in a direction parallel to the X-axis, so that the magnetic field distribution is more uniform and controllable, and output results are more stable. When the distance between the first magnetic flux conversion unit 21 and the second magnetic flux conversion unit 22 is large, the flux connection unit 24 can adopt a soft magnetic metal material structure that does not overlap with the first magnetic flux conversion unit 21 and the second magnetic flux conversion unit 22, which can also achieve the functions of guiding the magnetic field and improving accuracy. The converted X-axis magnetic field component points to the right at the position of the magnetic induction unit 31a, and to the left at the position of the magnetic induction unit 31b. The resistance value of the magnetic induction unit 31a decreases, while the resistance value of the magnetic induction unit 31b increases. Therefore, the magnetic induction units 31a and 31b can form a push-pull half-bridge structure to sense the magnetic field of the magnetic flux conversion module 2 and generate a differential voltage signal.

The output module in this embodiment adopts a closed-loop signal conditioning circuit and a magnetic field feedback coil. The closed-loop signal conditioning circuit, the magnetic field feedback coil, and the magnetic induction unit 31 constitute a closed-loop magnetic field feedback structure; after the closed-loop signal conditioning circuit amplifies the differential voltage signal, the magnetic field feedback coil generates a feedback magnetic field to achieve dynamic magnetic field balance; and the feedback current in the magnetic field feedback coil is sampled to form an output signal of the Z-axis magnetic field sensor. Depending on the actual situation, the magnetic field feedback coil can be positioned to be a coil that coil wraps in-plane on the plane formed by the X-axis and Y-axis on any upper or lower surface of the first base 1a, the first magnetic flux conversion unit 21, the magnetic induction unit 31, the magnetic flux connection unit 24, the second magnetic flux conversion unit 22, and the second base 1b, or a coil that wraps around the Z-axis direction on all four sides of the first base 1a and the second base 1b. Since the magnetic field feedback coil is an existing basic technology, it will not be described in detail. In this embodiment, the magnetic field feedback coil is positioned to be a coil that wraps around the Z-axis direction on all four sides of the first base 1a and the second base 1b.

The following is a processing method in this embodiment. As shown in FIG. 9, the first substrate 1a and the second substrate 1b are provided, a TMR magnetoresistive thin film is deposited on the surface of the first substrate 1a, and the magnetic induction units 31a and 31b are formed by means of semiconductor patterned microfabrication. A non-conductive passivation layer is deposited on the first substrate 1a to protect the magnetic induction unit 31, then a soft magnetic metal material is deposited above the passivation layer of the magnetic induction unit 31, and soft magnetic metal materials spaced apart in the X-axis direction are formed by means of semiconductor microfabrication, to form the magnetic flux connection unit 24. Groove are formed on the surfaces of the second substrate 1b and the first substrate 1a away from the TMR magnetoresistive thin film using the backside deep reactive ion etching (DRIE) process, the soft magnetic metal material is deposited in the grooves, and the chemical mechanical polishing (CMP) process is used for polishing to respectively form the first magnetic flux conversion unit 21 and the second magnetic flux conversion unit 22 in the magnetic flux conversion module 2. By means of a single-chip packaging process and through wafer-level advanced packaging (WLP) and through silicon via (TSV) processes, the plane where the tunnel magnetoresistor (TMR) of the first substrate 1a is located and the surface of the second substrate 1b with no groove opening are arranged in an opposite manner for packaging, copper conductors 4 are used to pass through the through silicon vias to form circuit connections, thereby forming a push-pull half-bridge structure, and lead pads and circuits are attached and packaged into a single chip. After the packaging, there are regions where soft magnetic metal materials of the first magnetic flux conversion unit 21 and the second magnetic flux conversion unit 22 are spaced apart in the X-axis direction, and in such regions, projections of the soft magnetic metal materials of adjacent first magnetic flux conversion unit 21 and second magnetic flux conversion unit 22 in the Z-axis direction do not overlap; and the projection of the soft magnetic metal material of the magnetic flux connection unit 24 in the Z-axis direction partially overlaps with the soft magnetic metal materials of the first magnetic flux conversion unit 21 and the second magnetic flux conversion unit 22. The packaged TMR magnetoresistive thin film is located in the Z-axis direction between the plane formed by the X-axis and Y-axis of the first magnetic flux conversion unit 21 and the plane formed by the X-axis and Y-axis of the second magnetic flux conversion unit 22, and also located between the first substrate 1a and the second substrate 1b; moreover, the projection in the Z-axis direction is not only located inside the soft magnetic metal material of the magnetic flux connection unit 24 (at the intervals), but also located at gaps between the soft magnetic material of the magnetic flux connection unit 24 and the soft magnetic materials of the first magnetic flux conversion unit 21 and the second magnetic flux conversion unit 22.

Therefore, this embodiment adopts single-chip packaging with two substrates arranged in an opposite manner and the backside deep reactive ion etching (DRIE) process, and introduces the magnetic flux connection unit 24. Based on the original enhancement of magnetic flux concentration and guidance by the first magnetic flux conversion unit 21 and the second magnetic flux conversion unit 22, magnetic flux concentration and guidance in the X-axis direction of the magnetic circuit are realized, thereby making the magnetic field distribution more uniform and controllable, the magnetic field gain greater, and output results more stable, which can further improve accuracy and sensitivity and reduce noise.

In addition, for the bridge structure of the present invention, besides using the magnetic induction unit 31 located at the position of spacing between the soft magnetic metal material and the reference resistor with a fixed resistance value as mentioned in the existing embodiments, a differential bridge can also be formed by combining a magnetic induction unit 32 (not shown in the figure) with projection along the Z-axis direction in the coverage range of soft magnetic metal materials or at other positions such as those away from the magnetic flux conversion module 2. Such cases are all basic existing technology and will not be described in detail.

## Claims

1. A Z-axis magnetic field sensor, **characterized in that** the Z-axis magnetic field sensor comprises
a substrate,
a magnetic flux conversion module,
a magnetic induction module, and
an output module;
the magnetic flux conversion module is disposed in a groove of the substrate or located above the substrate; the magnetic flux conversion module is used to modulate a magnetic field to be measured and generate a magnetic field component in the X-axis direction to form a target magnetic flux path; wherein the direction of the magnetic field to be measured is the Z-axis direction;
the magnetic induction module comprises at least two magnetic induction units; the magnetic induction units are arranged between the magnetic flux conversion modules along the Z-axis direction, and the magnetic induction units are used to generate differential voltage signals under the action of the target magnetic flux path; wherein the magnetic induction units comprise at least one magnetoresistive sensitive element, and the sensitivity directions of the magnetic induction units are the same;
the magnetic induction module employs at least one structure selected from differential full bridge, differential half bridge, push-pull full bridge, and push-pull half bridge to sense the magnetic field of the magnetic flux conversion module, generate a differential voltage signal, and form an output signal of the magnetic field to be measured through the output module;
wherein the plane on which the substrate is located is a plane formed by the X-axis and the Y-axis, the magnetic flux conversion module is disposed along the X-axis direction, and the plane perpendicular to the plane on which the substrate is located is the plane on which the Z-axis is located.

2. The Z-axis magnetic field sensor according to claim 1, **characterized in that** the magnetic flux conversion module comprises at least one first magnetic flux conversion unit and at least one second magnetic flux conversion unit;
the first magnetic flux conversion unit and the second magnetic flux conversion unit are disposed on two sides of the magnetic induction unit along the Z-axis direction; the first magnetic flux conversion unit and the second magnetic flux conversion unit are used to concentrate and amplify the magnetic field to be measured to form the target magnetic flux path, and generate a magnetic field component in the X-axis direction at the position of spacing between the first magnetic flux conversion unit and the second magnetic flux conversion unit;
wherein the projections of the first magnetic flux conversion unit and the second magnetic flux conversion unit on the X-axis do not overlap or the overlapping portion is less than an overlap threshold.

3. The Z-axis magnetic field sensor according to claim 2, **characterized in that** the substrate comprises a first substrate and a second substrate;
the first magnetic flux conversion unit is disposed in a groove of the first substrate, and the second magnetic flux conversion unit is disposed in a groove of the second substrate.

4. The Z-axis magnetic field sensor according to claim 3, **characterized in that** the magnetic induction unit comprises at least one first magnetic induction unit and at least one second magnetic induction unit;
the first magnetic induction unit and the second magnetic induction unit are disposed along the Z-axis direction, such that the first magnetic induction unit and the second magnetic induction unit are located in two different planes formed by the X-axis and the Y-axis, respectively;
the first magnetic induction unit is integrated on the first substrate, and the second magnetic induction unit is integrated on the second substrate; and the first magnetic induction unit and the second magnetic induction unit have the same or different sensitivity directions.

5. The Z-axis magnetic field sensor according to claim 2, **characterized in that** the magnetic flux conversion module further comprises a magnetic flux connection unit;
the magnetic flux connection unit is disposed between the first magnetic flux conversion unit and the second magnetic flux conversion unit; wherein the material of the magnetic flux connection unit is a soft magnetic metal material;
the soft magnetic metal material of the magnetic flux connection unit is distributed along the X-axis direction, connects the magnetic flux paths of the first magnetic flux conversion unit and the second magnetic flux conversion unit, and guides them along a direction parallel to the X-axis;
and the magnetic induction unit is disposed inside the soft magnetic metal material of the magnetic flux connection unit or at a gap between the soft magnetic metal materials of the magnetic flux conversion modules.

6. The Z-axis magnetic field sensor according to claim 2, **characterized in that** the magnetic flux conversion module further comprises an enhanced magnetic flux conversion unit;
the enhanced magnetic flux conversion unit is superimposed on the first magnetic flux conversion unit and/or the second magnetic flux conversion unit in the Z-axis direction to further concentrate and amplify the magnetic field to be measured.

7. The Z-axis magnetic field sensor according to claim 1, **characterized in that** the magnetic induction units are respectively formed by connecting in series and parallel at least one magnetoresistive sensitive element; wherein the magnetoresistive sensitive element is any one of anisotropic magnetoresistors (AMR), giant magnetoresistors (GMR), or tunnel magnetoresistors (TMR).

8. The Z-axis magnetic field sensor according to claim 1, **characterized in that** the output module comprises an open-loop signal conditioning circuit, or a closed-loop signal conditioning circuit and a magnetic field feedback coil;
the open-loop signal conditioning circuit performs conditioning, amplification, temperature compensation, and linearity correction on the differential voltage signal and then forms an output signal of the Z-axis magnetic field sensor;
the closed-loop signal conditioning circuit, the magnetic field feedback coil, and the magnetic induction unit constitute a closed-loop magnetic field feedback structure; after the closed-loop signal conditioning circuit amplifies the differential voltage signal, the magnetic field feedback coil generates a feedback magnetic field to achieve dynamic magnetic field balance; and the feedback current in the magnetic field feedback coil is sampled to form an output signal of the Z-axis magnetic field sensor.

9. The Z-axis magnetic field sensor according to claim 1, **characterized in that** the Z-axis magnetic field sensor further comprises lead pads and a mechanical support housing; and the Z-axis magnetic field sensor is manufactured using a single-chip integration process.

10. A processing method for a Z -axis magnetic field sensor, **characterized in that** the processing method is used to process a Z-axis magnetic field sensor comprising a substrate, a magnetic flux conversion module, and a magnetic induction module; the magnetic induction module comprises at least two magnetic induction units; the magnetic flux conversion module comprises at least one first magnetic flux conversion unit and at least one second magnetic flux conversion unit; and the processing method comprises:
depositing an MR magnetoresistive thin film on the surface of the substrate and then processing to form the magnetic induction unit;
depositing a passivation layer on the surface of the substrate on which the magnetic induction unit is deposited; wherein the passivation layer is used to protect the magnetic induction unit;
forming one or more grooves spaced apart on the substrate along the X-axis direction, and depositing a soft magnetic metal material having a high magnetic permeability in the grooves to form the first magnetic flux conversion unit in the magnetic flux conversion module;
forming one or more soft magnetic metal materials spaced apart above the passivation layer of the substrate by means of deposition and semiconductor microfabrication, to form the second magnetic flux conversion unit in the magnetic flux conversion module;
the first magnetic flux conversion unit and the second magnetic flux conversion unit are evenly arranged on two sides of the magnetic induction unit; wherein the projections of the first magnetic flux conversion unit and the second magnetic flux conversion unit on the X-axis do not overlap or the overlapping portion is less than an overlap threshold;
wherein the magnetic flux conversion module is used to modulate a magnetic field to be measured in the Z-axis direction and generate a magnetic field component in the X-axis direction to form a target magnetic flux path; the magnetic induction unit is used to generate a differential voltage signal under the action of the target magnetic flux path; the plane on which the substrate is located is a plane formed by the X-axis and the Y-axis, the magnetic flux conversion module is disposed along the X-axis direction, and the plane perpendicular to the plane on which the substrate is located is the plane on which the Z-axis is located.

11. The processing method according to claim 10, **characterized in that** the groove is formed on the substrate using a backside deep reactive ion etching (DRIE) process, and the groove opening is located on the surface of the substrate away from the MR magnetoresistive thin film;
and after depositing the soft magnetic metal material, the chemical mechanical polishing (CMP) process is used for polishing.

12. The processing method according to any one of claims 10-11, **characterized in that** one or more soft magnetic metal materials spaced apart along the X-axis direction are deposited on the surface where the MR magnetoresistive thin film is located and/or on the substrate surface adjacent to the MR magnetoresistive thin film to form a magnetic flux connection unit.

13. The processing method according to any one of claims 10-11, **characterized in that** an enhanced magnetic flux conversion unit is superimposed along the Z-axis direction on the second magnetic flux conversion unit formed by depositing a soft magnetic metal material on the surface of the substrate away from the MR magnetoresistive thin film and/or on the surface on which the substrate MR magnetoresistive thin film is located.

14. The processing method according to any one of claims 10-11, **characterized in that** the MR magnetoresistive thin film comprises an anisotropic magnetoresistor (AMR), a giant magnetoresistor (GMR), or a tunnel magnetoresistor (TMR).

15. The processing method according to any one of claims 10-11, **characterized in that** the Z-axis magnetic field sensor adopts single-chip packaging, and is packaged into a single chip by means of wafer-level packaging (WLP) and through silicon via (TSV) processes to attach lead pads and circuits.

16. A processing method for a Z -axis magnetic field sensor, **characterized in that** the processing method is used to process a Z-axis magnetic field sensor comprising a substrate, a magnetic flux conversion module, and a magnetic induction module; the magnetic induction module comprises at least two magnetic induction units; the magnetic flux conversion module comprises at least one first magnetic flux conversion unit and at least one second magnetic flux conversion unit; and the processing method for a Z -axis magnetic field sensor comprises:
forming one or more soft magnetic metal materials spaced apart above the substrate by means of deposition and semiconductor microfabrication, to form the first magnetic flux conversion unit,
using the chemical mechanical polishing (CMP) process to perform polishing, and depositing a passivation layer;
depositing an MR magnetoresistive thin film on the surface of the passivation layer, and processing to form the magnetic induction unit;
after depositing a passivation layer above the magnetic induction unit again, forming one or more soft magnetic metal materials spaced apart by means of deposition and semiconductor microfabrication, so as to form the second magnetic flux conversion unit;
the first magnetic flux conversion unit and the second magnetic flux conversion unit are evenly arranged on two sides of the magnetic induction unit; wherein the projections of the first magnetic flux conversion unit and the second magnetic flux conversion unit on the X-axis do not overlap or the overlapping portion is less than an overlap threshold;
wherein the magnetic flux conversion module is used to modulate a magnetic field to be measured and generate a magnetic field component in the X-axis direction to form a target magnetic flux path; the magnetic induction unit is used to generate a differential voltage signal under the action of the target magnetic flux path; the plane on which the substrate is located is a plane formed by the X-axis and the Y-axis, the magnetic flux conversion module is disposed along the X-axis direction, and the plane perpendicular to the plane on which the substrate is located is the plane on which the Z-axis is located.

17. The processing method according to claim 16, **characterized in that** one or more soft magnetic metal materials spaced apart along the X-axis direction are deposited on the surface where the MR magnetoresistive thin film is located and/or on the substrate surface adjacent to the MR magnetoresistive thin film to form a magnetic flux connection unit.

18. The processing method according to claim 16, **characterized in that** an enhanced magnetic flux conversion unit is superimposed along the Z-axis direction on the second magnetic flux conversion unit formed by depositing a soft magnetic metal material on the surface of the substrate away from the MR magnetoresistive thin film and/or on the surface on which the substrate MR magnetoresistive thin film is located.

19. The processing method according to claim 16, **characterized in that** the MR magnetoresistive thin film comprises an anisotropic magnetoresistor (AMR), a giant magnetoresistor (GMR), or a tunnel magnetoresistor (TMR).

20. The processing method according to claim 16, **characterized in that characterized in that** the Z-axis magnetic field sensor adopts single-chip packaging, and is packaged into a single chip by means of wafer-level packaging (WLP) and through silicon via (TSV) processes to attach lead pads and circuits.

21. A processing method for a Z -axis magnetic field sensor, **characterized in that** the processing method is used to process a Z-axis magnetic field sensor comprising a substrate, a magnetic flux conversion module, and a magnetic induction module; the magnetic induction module comprises at least two magnetic induction units; the magnetic flux conversion module comprises at least one first magnetic flux conversion unit and at least one second magnetic flux conversion unit; the substrate comprises a first substrate and a second substrate; and the processing method for a Z - axis magnetic field sensor comprises:
depositing an MR magnetoresistive thin film on the surface of the first substrate, then processing to form the magnetic induction unit, and depositing a passivation layer on the surface of the first substrate on which the magnetic induction unit is deposited;
forming one or more grooves spaced apart on the surface of the first substrate away from the MR magnetoresistive thin film by using the backside deep reactive ion etching (DRIE) process on the first substrate;
depositing a soft magnetic metal material in the groove, and using the chemical mechanical polishing (CMP) process to perform polishing to form the first magnetic flux conversion unit in the magnetic flux conversion module;
using the same process flow for the second substrate as the one for the first substrate to form the magnetic induction unit and the second magnetic flux conversion unit, or not depositing an MR magnetoresistive thin film, using the same subsequent process flow as the one for the first substrate, forming one or more grooves spaced apart by using the backside DRIE process,
depositing a soft magnetic metal material, and then using the CMP process to form the second magnetic flux conversion unit;
arranging the first substrate and the second substrate in an opposite manner along the Z-axis direction by means of the wafer-level packaging (WLP) process, and arranging the first magnetic flux conversion unit and the second magnetic flux conversion unit evenly on two sides of the magnetic induction unit; wherein the projections of the first magnetic flux conversion unit and the second magnetic flux conversion unit on the X-axis do not overlap or the overlapping portion is less than an overlap threshold;
the MR magnetoresistive thin film is located adjacent to the position of spacing between the first magnetic flux conversion unit and the second magnetic flux conversion unit in the X-axis direction; wherein the MR magnetoresistive thin films on the first substrate have the same sensitivity direction, and the MR magnetoresistive thin films on the second substrate have the same sensitivity direction;
in the case where the second substrate contains a magnetic induction unit, after the first substrate and the second substrate are disposed in an opposite manner along the Z-axis direction and packaged, the sensitivity directions of the first magnetic induction unit and the second magnetic induction unit are both parallel to the plane formed by the X-axis and the Y-axis.

22. The processing method according to claim 21, **characterized in that** one or more soft magnetic metal materials spaced apart along the X-axis direction are deposited on the surface where the MR magnetoresistive thin film is located and/or on the substrate surface adjacent to the MR magnetoresistive thin film to form a magnetic flux connection unit.

23. The processing method according to claim 21, **characterized in that** an enhanced magnetic flux conversion unit is superimposed along the Z-axis direction on the second magnetic flux conversion unit formed by depositing a soft magnetic metal material on the surface of the substrate away from the MR magnetoresistive thin film and/or on the surface on which the substrate MR magnetoresistive thin film is located.

24. The processing method according to claim 21, **characterized in that** the MR magnetoresistive thin film comprises an anisotropic magnetoresistor (AMR), a giant magnetoresistor (GMR), or a tunnel magnetoresistor (TMR).

25. The processing method according to claim 21, **characterized in that characterized in that** the Z-axis magnetic field sensor adopts single-chip packaging, and is packaged into a single chip by means of wafer-level packaging (WLP) and through silicon via (TSV) processes to attach lead pads and circuits.
